# EUROPEAN PATENT SPECIFICATION

(11) **EP 0 332 335 B1**
(45) Date of publication and mention of the grant of the patent: **30.11.1994**
(21) Application number: 89302030.5
(22) Date of filing: 01.03.1989
(51) Int. Cl.: G09F 9/30, B67D 5/22, G06F 15/22

(54) **Display device**
Anzeigevorrichtung
Dispositif d'affichage

(30) Priority: 08.03.1988 JP 54154/88
(43) Date of publication of application: 13.09.1989
(73) Proprietor: TOKYO TATSUNO COMPANY LIMITED, Minato-ku Tokyo (JP)
(72) Inventor: Ishibashi, Kazuhiro Tokyo Tatsuno Company Limited, Tokyo (JP); Satoh, Yoshiyuki Tokyo Tatsuno Company Limited, Tokyo (JP)
(74) Representative: Quest, Barry

(56) References cited:
- FR-A- 2 463 469
- US-A- 4 750 130
- PATENT ABSTRACTS OF JAPAN, vol. 4, no. 8 (E-166), 22th January 1980;& JP-A-54 147 797 (SUWA SEIKOSHA) 19-11-1979
- PATENT ABSTRACTS OF JAPAN, vol. 2, no. 137, 15th November 1978; & JP-A-53 104 196 (SUWA SEIKOSHA) 11-09-1978

## Description

The present invention relates to a display device used, for instance, as a display for a fuel delivery apparatus, and more particularly to a display device having segments arranged for indicating digits and/or characters.

In the past, a seven-segment type display device has mainly been used for indicating fuel delivery data, such as a delivered fuel volume, a total price to be paid, a unit volume price, etc. (vide, for instance, U.S. Pat. No. 4,216,529 issued Aug. 5, 1980 to Krystek et al.).

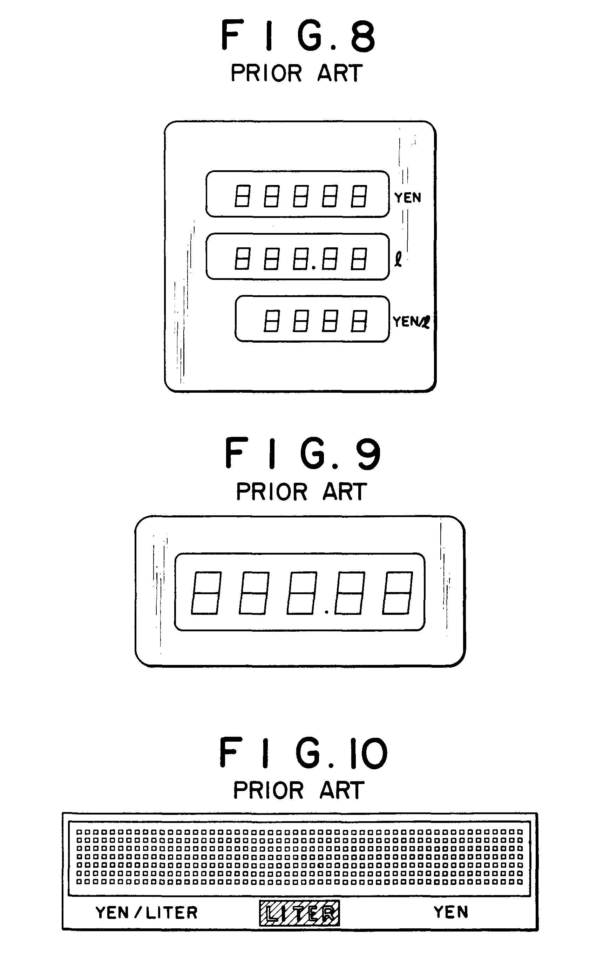

This type of display device can generally be classified into a so-called price indicating type which indicates, as the fuel delivery data, not only the delivered fuel volume but also the total price to be paid and the unit volume price, as shown in Fig. 8 and a so-called delivered fuel volume indicating type which indicates solely the delivered fuel volume on a large scale, as shown in Fig. 9. They are selectively used in accordance with a definite object in view in an every fuel delivery station.

The above two types of display device are similar to one another so far as their function is concerned, but different from each other in their standards concerning the size etc., so that the parts thereof such as a display panel and a driving circuit therefor are not exchangeable therebetween, which makes them expensive and inconvenient.

In order to eliminate such an inexpedience, a dot-matrix display as shown in Fig. 10 has been provided, which has a great number of dots such as small light tubes, light emission diodes and liquid crystal segments, closely aggregated in regular order so as to be usable as the delivered fuel volume indicating type indicating the delivered fuel volume on a large scale at the central portion of the display panel, and as the price indicating type indicating the total price to be paid and the unit volume price on a relatively reduced scale (vide, for instance, U.S. Pat. No. 4,750,130 issued June 7, 1988 to Shimamura et al and JP-A-54147797.2). This dot-matrix display can display, other than digits, English or other country's characters, abbreviations, marks or symbols, etc., and therefore it is convenient to use and can be used in various ways.

However, these dot-matrix displays are disadvantageous in that the panel and the driving circuit thereof are constructionally complicated and expensive as compared with the seven-segment type display.

FR-A-2,463,469 discloses an alphanumerical display having four transverse segments and six vertical segments of unequal lengths. Due to the configuration of segments the display consequently lacks versatility in display.

### SUMMARY OF THE INVENTION

An object of the invention is to provide a display device which is as simple in construction and inexpensive as the seven-segment type display and can be used in common either as the delivered fuel volume indicating type indicating a delivered fuel volume on a large scale or as the price indicating type indicating a delivered fuel volume and a total price to be paid on a relatively reduced scale.

The object can be attained according to the invention, by providing a display device for fuel dispensing systems, including at least one displaying unit comprising multiple transverse segments disposed one above the other and extending generally parallel to each other and multiple vertical segments disposed at each side of the transverse segments to connect the ends of adjacent transverse segments at each side thereof, each of said transverse and vertical segments being operable such that respective combinations of said segments can be operated to display digits in first and second modes, a first mode in which said segments display a single set of enlarged digits and a second mode in which said segments display two sets of digits simultaneously, one set of digits being displayed above the other, characterised in that each displaying unit comprises six substantially equally spaced transverse segments and ten vertical segments and in said second mode an upper three of said transverse segments and fourofsaid vertical segments connecting these three upper segments at each side thereof take part in displaying a first set of digits and a lower three of said transverse segments and four of said vertical segments connecting these three lower segments at each side thereof take part in displaying a second set of digits and in said first mode the alternate ones of said transverse segments and eight of said vertical segments connecting said alternate three transverse segments at each side thereof take part in displaying the set of digits. As understandable, the display device according to the invention can selectively be used at owner's request either as the delivered fuel volume indicating type or as the price indicating type, while the construction thereof is simple and easy to manufacture and easy to operate. Preferably, a plurality of displaying units are laterally arranged so that a several-digit displayment is made possible. Furthermore, it is preferable to dispose another lateral arrangement of a plurality of displaying units beneath the first lateral arrangement of displaying units so that an indicatory capability is expanded. When each of the displaying units in the lower lateral arrangement has nine segments arranged to form a lattice like 81 it becomes possible to indicate one of characters in, for instance, English.

### BRIEF DESCRIPTION OF THE DRAWINGS

Fig. 1 is a diagrammatic illustration of the fuel delivery apparatus in which the display device according to the invention is installed,
Fig. 2 is a block diagram of certain components participating in the display and control in the display device,
Fig. 3 is a front view of the display panel of the display device according to the invention,
Fig. 4 is a view similar to Fig. 2, but showing the panel used as the price indicating type,
Fig. 5 is a view similar to Fig. 2, but showing the panel used as the delivered fuel volume indicating type,
Fig. 6 is a view similar to Fig. 2, but showing the panel indicating another mode of display,
Fig. 7 is a front view of another display panel embodying the present invention,
Fig. 8 is a front view of a known panel of seven-segment type used as the price indicating type,
Fig. 9 is a front view of a known panel of seven-segment type used as the delivered fuel volume indicating type, and
Fig. 10 is a front view of a known panel of dot-matrix type.

### DESCRIPTION OF THE PREFERRED EMBODIMENTS

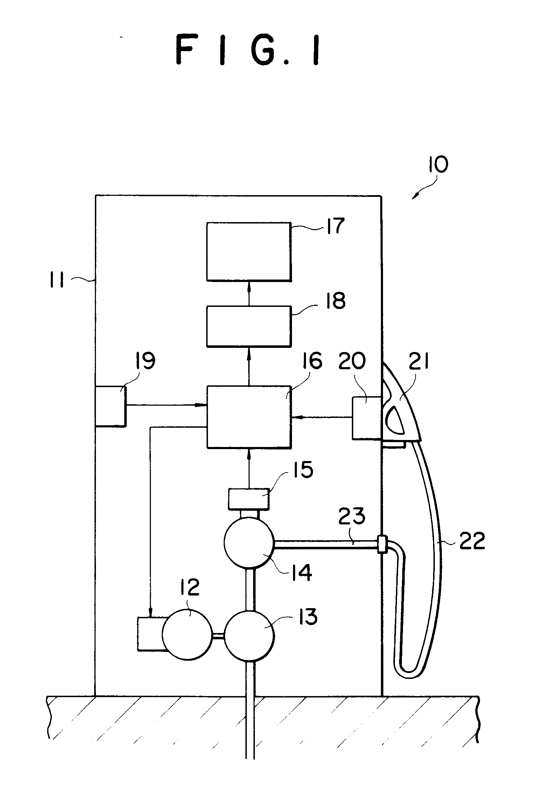

Referring to the drawings, particularly, to Fig. 1, the display device according to the present invention will be described in conjunction with its installation in a fuel delivery apparatus represented generally by 10.

The fuel delivery apparatus 10 has a casing 11 which contains a motor 12, a pump 13, a flow meter 14, a flow pulse generator 15, control means 16, a display panel 17, driving means 18, a selector switch 19 and a nozzle switch 20 for delivering a fuel- dispensing-operation-starting signal. A fuel delivery nozzle 21 is connected through a flexible hose 22 with the free end of a conduit 23 extending through the flow meter 14 and the pump 13 down to an underground fuel reservoir (not shown).

When the delivery nozzle 21 hung on a hook on the casing 11 is taken off for starting a fuel delivery, the nozzle switch 20 is actuated to energize the motor 2 through the control means 16, and consequently drive the pump 13 for feeding fuel to the nozzle 21 so that, when valve means therein is actuated, the fuel may be delivered to the vehicle. The flow meter 14 counts the amount of the fuel flowing therethrough and the flow pulse generator 15 generates corresponding pulse signals, which are processed by the control means 16 for selectively indicating the delivered fuel volume on the display panel 17 through the driving means 18.

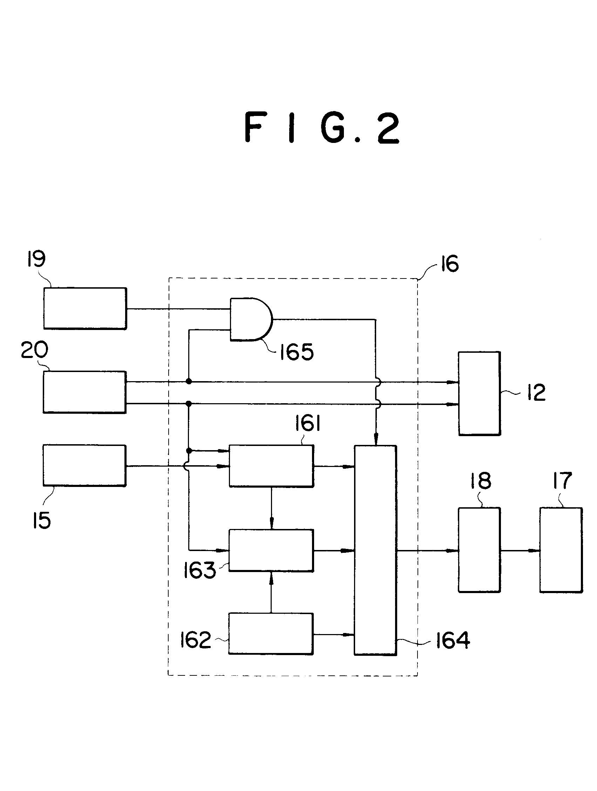

In reference to Fig. 2, the control means 16 encircled with a dotted line comprises a counter means 161 which integrates flow pulses given by the flow pulse generator 15 to output a delivered-fuel-volume signal, a memory 162 storing data of a unit volume price for producing a price-per-unit-quantity signal, and a calculating means 163 for calculating a total price based on the data given from the counter means 161 and the memory 162 to output a total-price signal. The control means 16 further comprises a display mode switching means 164 to which the above delivered-fuel-volume signal, price-per-unit-quantity signal and total-price signal are applied so as to selectively be transferred to the driving means 18 for activating segments in the display panel 17 which will be explained in greater detail below. The display mode switching means 164 is connected, through an AND gate 165, to the selector switch 19 which is manually operated for selecting the display modes which are to be indicated on the display panel 17. The AND gate 165 continually receives a corresponding signal from the selector switch 19 but does not deliver the corresponding signal to the display mode switching means 164 unless the fuel delivery nozzle 21 is hung up and the nozzle switch 20 is turned off. The last data in the counter means 161 and the calculating means 163 are reset to "zero" by taking up the fuel delivery nozzle 21 from a hook thereof for a next fuel delivery and therefore by turning on the nozzle switch 20.

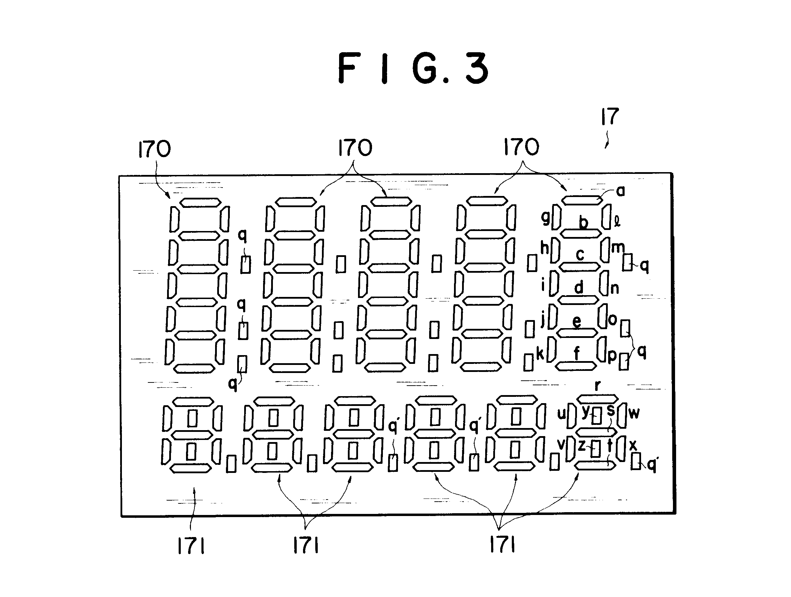

Referring now to Fig. 3, the shown embodiment of the display panel 17 has a number of display units 170 each of which consists of six transverse segments a-f, and ten vertical segments g-p. These segments may be conventional plasma or liquid crystal segments. The six transverse segments a-f are arranged in parallel in vertical direction with equally spacing, and ten vertical segments g-p are arranged at both sides of the transverse segments so as to connect the terminal ends of the each adjacent two transverse segments at each side thereof. In the embodiment, five displaying units 170 are laterally arranged so as to provide a five-digit cost/volume indicator. At the right side of each of the displaying units 170, three small segments q are arranged at the levels corresponding to third, fifth and sixth transverse segments c, e and f in order to represent respectively a decimal point.

Beneath the lateral row of the displaying units 170, there is another row of other displaying units 171 each of which consists of three transverse segments r-t, four vertical segments u-x arranged at both sides of the transverse segments r-t so as to connect the terminal ends of each adjacent two transverse segments at each side thereof, and two intermediate vertical segments y and z arranged between the opposed vertical segments, so that all the nine segments r-z of the displaying unit 171 form a lattice like which makes it possible to indicate one of digits or characters. Five such displaying units 171 are arranged in a row to indicate for instance a unit volume price or a word for the benefit of the consumer. On the right side of every displaying unit 171, a small segment q' similar to the segment q is arranged at the level corresponding to the bottom transverse segment t in order to represent a decimal point.

Now in operation, at first, the selector switch 19 is operated to render the display mode switching means 164 effective for transferring the selected signal or signals among the supplied signals to the driving means 18. Assuming that the display of the price indicating type is selected, when the nozzle 21 is taken off from the hookforfuel dispensation in Fig. 1, the control means 16 detects actuation of the nozzle switch 20 and energizes the pump motor 12 so that fuel is pumped up to flow through the flow meter 14, the conduit 23 and the hose 22 into the nozzle 21. Furthermore, upon turning on the nozzle switch 20, the former fuel delivery data in the counter means 161 and the calculating means 163 are reset to zero and accordingly the indication in the display panel 17 comes to zero of digit.

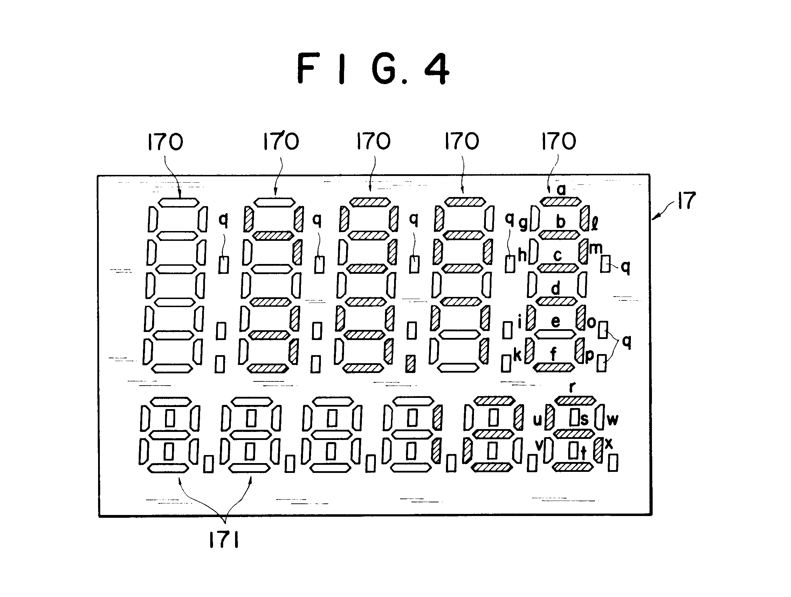

When a trigger (not shown) of the nozzle 21 now inserted in a filler pipe of an automobile is manually actuated, the fuel is introduced into the tank of the automobile and the flow pulse generator 15 commences generating flow pulses to be applied to the counter means 161 of the control means 16. The counter means 161 integrates the flow pulses to output the delivered-fuel-volume signal. At the same time, as mentioned in the above, the memory 162 for unit volume price outputs the price-per-unit-quantity signal and the calculating means 163 outputs the total-price signal. All the signals are applied to the display mode switching means 164 which, according to the indication previously set by the selector switch 19, sends a corresponding signal to the driving means 18 to render certain segments in the display panel 17 activate, as shown in Fig. 4.

As being clear from Fig. 4, when the display device is used as the price indicating type, the upper three transverse segments a-c and four vertical segments g, h, I, m are occupied in displaying the given information, e.g. "4963" (YEN), as the total price, and the lower three transverse segments d-f and the four vertical segments j, k, o, p as well as the small segments q are occupied in displaying the given information, e.g. "39.70" (LITRE), as the delivered fuel volume. The vertical segments i and n as well as the segments q disposed at the side of the transverse segments c and e are not used. The lower arrangement of the displaying units 171 is used for indicating the given information, e.g. "125" (YEN/LITRE), as the price per unit quantity with using the segments r-x. After completion of the fuel delivery operation, the fuel delivery nozzle 21 is hung on the hook whereby the nozzle switch 20 is turned off. Thereby the pump 13 is deenergized.

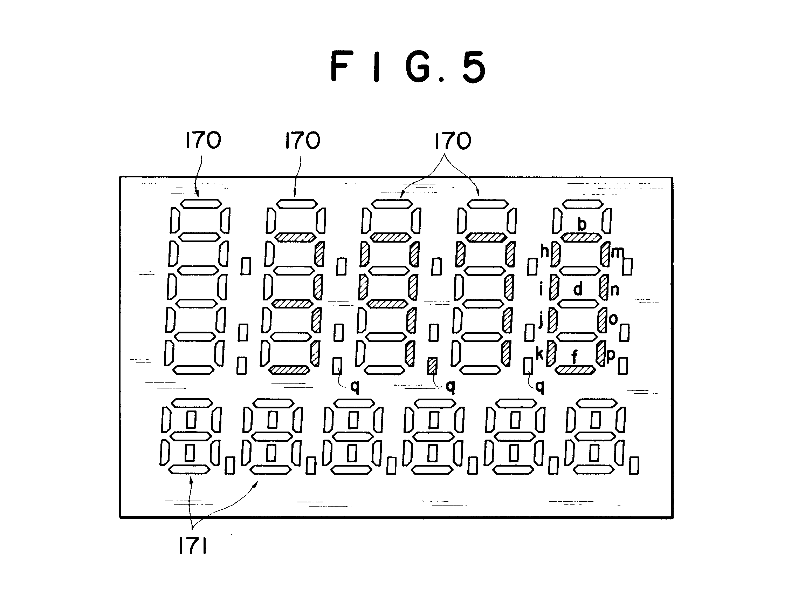

Fig. 5 shows another mode of the display in the case where the device is adopted as the delivered fuel volume indicating type, in which the three transverse segments in every second stair b, d, f and eight vertical segments h-k, m-p as well as the lower most small segments q of the upper row of the displaying units 170 are taken part in the display so as to indicate the given information, e.g. "3970" (LITRE), as the delivered fuel volume on a large scale for clearly confirmable. The other segments are not taken part in the display.

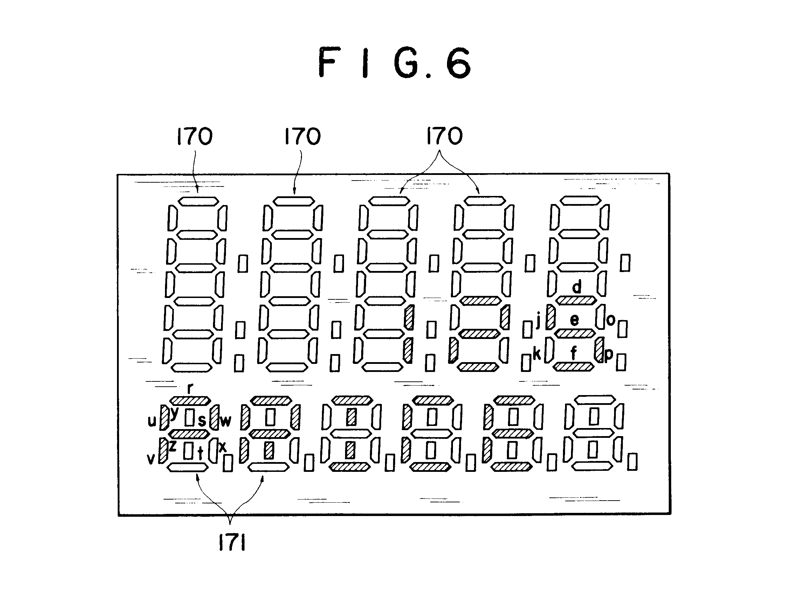

Fig. 6 shows still other mode of the display in which the lower row of the displaying units 171 is used for indicating a word such as, "PRICE", as shown, and the lower three transverse segments d-f and four vertical segments j, k, o, p of the upper row of the displaying units 170 are used for indicating the numerical information, e.g. "125" (YEN), so that the display panel 17 indicates as a whole that the price per unit volume is 125 YEN.

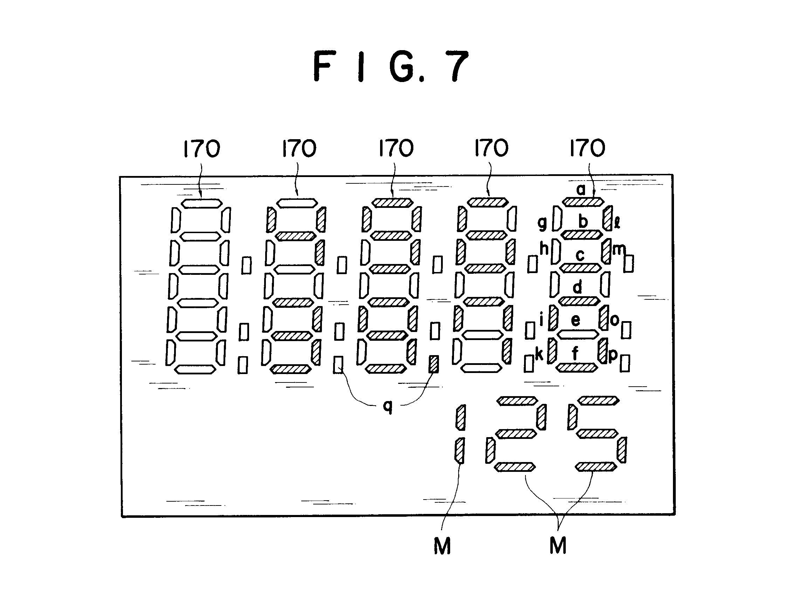

Fig. 7 shows a modification of the display mode shown in Fig. 4, wherein the lower row of the displaying units 171 are excluded, and instead, magnet pieces M of, for instance, ferrite formed in the shape of the above transverse and vertical segments may be used for indicating the price per unit volume by magnetically attaching the magnet pieces to a face of the display panel 17 of metal, in view of that the price per unit volume is a factor which is constant for a day.

From the foregoing, it can be readily realized that this invention can assume various embodiments. Thus, it is to be understood that the invention is not limited to the specific embodiments described herein.

Furthermore, although the display device described herein is particularly useful for the fuel delivery apparatus, it is to be understood that the device also has a number of applications in any environment where a display of quantity, price, etc. is desired.

## Claims

1. A display device for fuel dispensing systems, including at least one displaying unit comprising multiple transverse segments disposed one above the other and extending generally parallel to each other and multiple vertical segments disposed at each side of the transverse segments to connect the ends of adjacent transverse segments at each side thereof, each of said transverse and vertical segments being operable such that respective combinations of said segments can be operated to display digits in first and second modes, a first mode in which said segments display a single set of enlarged digits and a second mode in which said segments display two sets of digits simultaneously, one set of digits being displayed above the other, characterised in that each displaying unit comprises six substantially equally spaced transverse segments (a-f) and ten vertical segments (g-p) and in said second mode an upper three of said transverse segments (a-c) and four of said vertical segments (g, h, 1, m) connecting these three upper segments at each side thereof take part in displaying a first set of digits and a lower three of said transverse segments (d-f) and four of said vertical segments (j, k, o, p) connecting these three lower segments at each side thereof take part in displaying a second set of digits and in said first mode the alternate ones of said transverse segments (b, d, f; a, c, e) and eight of said vertical segments (h-k, m-p; g-j, I-o) connecting said alternate three transverse segments at each side thereof take part in displaying the set of digits.

2. A display device according to claim 1, wherein a plurality of displaying units (170) are provided disposed side by side, forming a first row of displaying units.

3. A display device according to claim 2, further comprising three small segments (q) arranged on a right side of each displaying unit (170) at levels corresponding to third, fifth and sixth transverse segments respectively from the top which are operable to be displayed in different display modes to represent a decimal point.

4. A display device according to claim 3, further comprising a second row of displaying units (171) disposed in side by side disposition below said first row.

5. A display device according to claim 4, wherein each of the displaying units (171) in said second row has nine segments (r-z) arranged to form a lattice like s .

6. A display device according to claim 5, further comprising a small segment (q') on the right side of each displaying unit (171) in the second row at a level corresponding to the bottom transverse segment in order to represent a decimal point.

7. A display device according to claim 6, further comprising means (18) for driving the display segments and control means (16) which has a counter means (161) receiving pulses from a flow pulse generator (15) to output a delivered-fuel-volume signal, a memory (162) storing data of a unit volume price for producing a price-per-unit-quantity signal, calculating means (163) for calculating a total price based on the data given from the counter means (161) and the memory (162) to output a total-price signal, and display mode switching means (164) receiving the above signals to deliver a signal corresponding to a selected display mode to the driving means (18).

8. A display device according to claim 7, further comprising a selector switch (19) connected to the display mode switching means (164) in order to switch the display modes.

9. A display device according to claim 8, wherein the display mode switching means (164) is provided with a mode switching signal only when a fuel delivery nozzle (21) is hung on a hook during which a nozzle switch (20) is turned off.

## Patentansprüche

1. Eine Anzeigevorrichtung für Kraftstoff-Zapfanlagen mit mindestens einerAnzeige-Einheit, bestehend aus mehreren transversalen, übereinander angeordneten Segmenten, die sich parallel zueinander ausdehnen, sowie mehreren vertikalen Segmenten, die zu beiden Seiten der transversalen Segmente angeordnet sind, um die seitliche Verbindung der jeweiligen transversalen Segmente herzustellen, wobei die erwähnten transversalen und vertikalen Segmente durch die jeweilige Kombination der erwähnten Segmente bei der Bedienung Zahlen in einem ersten und zweiten Modus anzeigen;
dabei zeigen die erwähnten Segmente im ersten Modus einen einzigen Satz vergrößerter Zahlen an,
während die erwähnten Segmente in einem zweiten Modus zwei übereinanderliegende Zahlensätze gleichzeitig anzeigen,
dadurch gekennzeichnet,
daß jede Anzeige-Einheit aus sechs in gleichmäßigen Abständen angeordneten transversalen Elementen (a-e) sowie zehn vertikalen Elementen (g-p) besteht,
wobei in der erwähnte zweite Modus drei der erwähnten oberen transversalen Elemente (a-c) sowie vier der erwähnten vertikalen Segmente (g, h, I, m), die die seitliche Verbindung dieser drei oberen Segmente herstellen, verwendet werden, um einen ersten Zahlensatz anzuzeigen, während die unteren drei der erwähnten transversalen Segmente (d-f) sowie vier der erwähnten vertikalen Segmente (j, k, o, p), die die seitliche Verbindung dieser drei unteren Segmente herstellen, verwendet werden, um einen zweiten Zahlensatz anzuzeigen; wobei in dem erwähnten ersten Modus dagegen werden jedes zweite der erwähnten transversalen Segmente (b, d, f; a, c, e) sowie acht der erwähnten vertikalen Segmente (h-k; m-p; g-j; I-o), die die seitliche Verbindung der entsprechenden drei transversalen Segmente herstellen, zur Anzeige des Zahlensatzes verwendet.

2. Eine Anzeigevorrichtung gemäß Patentanspruch 1, mit einer vielzahl nebeneinanderliegender Anzeigeeinheiten (170), die eine erste Reihe von Anzeigen bilden.

3. Eine Anzeigevorrichtung gemäß Patentanspruch 2, mit drei kleinen, zusätzlichen Segmenten (q) an der rechten Seite jeder Anzeigeeinheit (170), die, von oben aus gezählt, jeweils auf der Höhe des dritten, fünften und sechsten transversalen Elements liegen, und in verschiedenen Anzeigemodi zur Darstellung einer Kommastelle verwendet werden können.

4. Eine Anzeigevorrichtung gemäß Patentanspruch 3, mit einer zusätzlichen zweiten Reihe von nebeneinanderliegenden Anzeigeeinheiten (171) unterhalb der erwähnten ersten Reihe.

5. Eine Anzeigevorrichtung gemäß Patentanspruch 4, wobei jede der Anzeigeeinheiten (171) in der erwähnten zweiten Reihe neun Segmente (r-z) enthält, die ein Gitter bilden wie s .

6. Eine Anzeigevorrichtung gemäß Patentanspruch 3, mit einem zusätzlichen kleinen Segment (q'), an der rechten Seite jeder Anzeigeeinheit (171) der zweiten Reihe auf der Höhe des untersten transversalen Segments, das zur Darstellung einer Kommastelle verwendet werden kann.

7. Eine Anzeigevorrichtung gemäß Patentanspruch 6, die, außerdem über Mittel (18) für den Antrieb der Anzeigesegmente verfügt, sowie über eine Steuerung (16) mit einem Zähler (161), der von einem Durchfluß-Impulsgenerator (15) Impulse für die Ausgabe eines Volumeneinheitspreises erhält, mit einem Speicher (162) beinhaltet welcher den Preis-pro-Einheit der zur Erzeugung eines Einheit-Mengenpreis-Signals dient, mit Berechnungsmittel (163) zur Berechnung eines Gesamtpreises, der auf den vom Zähler (161) und vom Speicher gelieferten Daten beruht, für die Ausgabe eines Gesamtpreis-Signals, sowie über eine Umschaltvorrichtung (164) für den Anzeigemodus, die die oben erwähnten Signale empfängt und ein Signal an die Steuerung (18) weitergibt, das dem gewählten Anzeigemodus entspricht.

8. Eine Anzeigevorrichtung gemäß Patentanspruch 7, mit einem Wahlschalter (19) für die Umschaltvorrichtung (164) des Anzeigemodus, damit in den jeweiligen Anzeigemodus umgeschaltet werden kann.

9. Eine Anzeigevorrichtung gemäß Patentanspruch 8, wobei die Umschaltvorrichtung (164) des Anzeigemodus nur dann ein Modus-Umschaltsignal empfängt, wenn ein Kraftstoff-Zapfhahn (21) wieder eingehängt wird, wodurch ein Zapfhahnschalter (20) ausgeschaltet wird.

## Revendications

1. Dispositif d'affichage pour un dispositif distributeur de carburant incluant au moins une unité d'affichage comprenant une pluralité de segments transversaux disposés les uns au-dessus des autres et s'étendant généralement parallèles les uns par rapport aux autres, et une pluralité de segments verticaux disposés de chaque côté des segments transversaux pour relier de chaque côté les extrémités des segments transversaux adjacents entre eux, chacun des segments transversal et vertical étant utilisable de telle sorte que des combinaisons particulières desdits segments peuvent être utilisées pour afficher des chiffres dans un premier et second mode, un premier mode dans lequel lesdits segments affichent une seule série de chiffres agrandis et un second mode dans lequel lesdits segments affichent deux séries de chiffres simultanément, une série des chiffres étant affichée au-dessus l'autre, caractérisé en ce que chaque unité d'affichage comprend six segments (a-f) transversaux d'écartement sensiblement égal et dix segments verticaux (g-p) ; en ce que dans ledit second mode, un groupe supérieur de trois desdits segments transversaux (a-c) et quatre desdits segments verticaux (g, h, I, m) reliant de chaque côté ces trois segments supérieurs prennent part à l'affichage d'une première série de chiffres, et qu'un groupe inférieur des trois desdits segments transversaux (d-f) et quatre desdits segments verticaux (j, k, o, p) reliant de chaque côté ces trois segments inférieurs prennent part à l'affichage d'une seconde série de chiffres ; et en ce que dans le premier mode, un groupe alterné des dix segments transversaux (b, d, f ; a, c, e) et huit desdits segments verticaux (h-k, m-p ; g-j, I-o) reliant de chaque côté ledit groupe alterné de trois segments transversaux prennent part à l'affichage d'une série de chiffres.

2. Dispositif d'affichage selon la revendication 1, caractérisé en ce qu'une pluralité d'unités d'affichage (170) sont prévues disposées côte-à-côte en formant une première ligne d'unité d'affichage.

3. Dispositif d'affichage selon la revendication 2, caractérisé en ce qu'il comprend de plus trois petits segments (q) disposés sur le côté droit de chacune des unités d'affichage (170) à un niveau correspondant respectivement au troisième, cinquième et sixième segment transversal à partir du haut, et qui sont utilisables pour afficher selon les différents modes d'affichage un point décimal.

4. Dispositif d'affichage selon la revendication 3, caractérisé en ce qu'il comprend une seconde ligne d'unités d'affichage (171) disposées côte-à-côte juste en-dessous de la première ligne.

5. Dispositif d'affichage selon la revendication 4, caractérisé en ce que chacune des unités d'affichage (171) de la seconde ligne comprend neuf segments (r-z) disposés de telle sorte à former une fenêtre treillissée tel que ES:

6. Dispositif d'affichage selon la revendication 5, caractérisé en ce qu'il comprend de plus un petit segment (q') sur le côté droit de chaque unité d'affichage (171) de la seconde ligne, et ce à un niveau correspondant au segment transversal inférieur de telle sorte à représenter un point décimal.

7. Dispositif d'affichage selon la revendication 6, caractérisé en ce qu'il comprend de plus des moyens (18) pour piloter les segments d'affichage et des moyens de contrôle (16) comprenant des moyens de comptage (161) recevant des impulsions d'un générateur de flots d'impulsions (15) pour délivrer un signal du volume-de-carburant-distribué, une mémoire (162) stockant des données d'un prix par unité de volume pour produire un signal de prix-par-unité-quantité, des moyens de calcul (163) pour calculer un-prix total sur la base des données fournies par les moyens de comptage (161) et par la mémoire (162) pour fournir un signal du prix-total, et des moyens (164) de basculement de mode d'affichage recevant les signaux mentionnés précédemment pour fournir un signal correspondant à un mode d'affichage sélectionné, et ce aux moyens de pilotage (18).

8. Dispositif d'affichage selon la revendication 7,
caractérisé en ce qu'il comprend de plus un commutateur de sélection (19) relié aux moyens de basculement de mode d'affichage (164) de telle sorte à choisir le mode d'affichage.

9. Dispositif d'affichage selon la revendication 8, caractérisé en ce que les moyens de basculement de mode d'affichage (164) ne reçoivent un signal de basculement de mode seulement lorsque le pistolet de distribution de carburant (21) est suspendu à un crochet faisant qu'un interrupteur de pistolet (20) est en position "zéro".
